# EUROPEAN PATENT APPLICATION

(11) **EP 1 791 185 A1**
(43) Date of publication of application: **30.05.2007**
(21) Application number: 04771122.1
(22) Date of filing: 27.07.2004
(51) Int. Cl.: H01L 33/00

(54) **LIGHT-EMITTING ELEMENT, LIGHT-EMITTING DEVICE AND INFORMATION DISPLAY**

(71) Applicant: Quantum 14 KK, Koganei-shi, Tokyo 184-8588 (JP); Koshida, Nobuyoshi, Tokyo 184-0003 (JP)
(72) Inventor: KOSHIDA, Nobuyoshi, Koganei-shi, Tokyo 184-0003 (JP); KOJIMA, Akira, Oume-shi, Tokyo 198-0061 (JP)
(74) Representative: Hall, Matthew Benjamin
(86) International application number: PCT/JP2004/011026
(87) International publication number: WO 2006/011237

(57) **Abstract**

A light-emitting device has a structure in which a semiconductor or a conductive substrate having a bottom electrode, a layer for generating hot electrons, quasi-ballistic electrons or ballistic electrons, a luminous layer, and a semitransparent surface electrode are deposited, or a structure in which a holes supply layer is provided between the luminous layer and the semitransparent surface electrode having the same structure. The light-emitting device realizes highly efficient light emission in a range from infrared rays to ultraviolet ray with smaller driving current than that of conventional injection-type or intrinsic EL devices.

## Description

### Technical Field

The present invention relates to a solid-state light-emitting device which has several advantages (a thin-filmstructure, low power consumption, high resolution, high speed response, and low cost). The device is useful as a surface-emitting light source, a self-light-emitting display, a optical integrated light-emitting device, and the like.

### Background Art

Conventionally, light-emitting devices are widely used for display devices of information devices including mobile terminals, optical communication, light, and the like. For example, visible range light-emitting devices are key components for realizing active displays and personal information assistance. In the optical communication, near-infrared light-emitting devices are very important.

Since solid light-emitting devices which do not operate in neither vacuum nor gas are advantageous to device thinning and lightening, and have excellent environment resistance and excellent reliability, they are researched and developed a lot. Such solid light-emitting devices are roughly divided into carrier injection-type EL which obtains light emission due to recombination of electrons and holes injected into a luminous layer, and intrinsic EL which obtains light emission due to hot-electron excitation in a luminous layer. Some of them partially specify requisites such as tunability of luminescence wavelength, low power consumption, quick response, compatibility to enlargement of an area, environmental resistance, reliability, easiness of production. The device, however, which meets with all these requirements has not been realized.

The basic principle of the light emission in the carrier injection-type EL is diffusive injection of minority carriers through a pn-junction, and the basic principle in the intrinsic EL is excitation of light-emitting center due to hot electrons generated in a luminous layer. For this reason, in both the ELs, loss during the injection or drift of electrons and holes cannot be avoided, so that the simultaneous pursuit of the luminous efficiency and the power consumption is limited in achievement. When these EL devices are applied to displays, luminescent materials available for tuning emission color are limited in performance. So the manufacturing step becomes complicated. As a result, high integration becomes difficult.

It is, therefore, an object of the present invention to provide a light-emitting device which solves the above technical problems, has low power consumption, can enhance the luminous efficiency, has many choices of luminescent materials for application to display. Another object of the invention is to provide a highly integrated light-emitting device based on planar processing.

### Disclosure of Invention

In order to solve the above problem, the present invention from a first aspect provides a light-emitting device, characterized by including a device structure in which a semiconductor or a conductive substrate having a rear electrode, an electron drift layer for generating hot electrons, quasi-ballistic electrons or ballistic electrons, a luminous layer, and a semitransparent surface electrode are deposited. The invention from a second aspect provides the light-emitting device characterized in that a holes supply layer is deposited between the luminous layer and the semitransparent surface electrode of above-mentioned light-emitting device, and a hole is injected into the luminous layer under operation.

The invention from a third aspect provides the light-emitting device characterised in that the substrate comprises a glass plate or a plastic sheet coated with an electrode of above-mentioned device. The invention from a fourth aspect provides the light-emitting device, characterized in that the electron drift layer comprises a layer which is obtained in a manner that a semi-insulating film, a semiconductor film having a nanocrystalline structure, a semiconductor film or a polycrystalline semiconductor film is subject to nanocrystallization treatment. The invention from a fifth aspect provides the light-emitting device, characterized in that the luminous layer comprises a luminescent semiconductor, a luminescent semiconductor nanostructure, an inorganic fluorescent material or an organic fluorescent material, and can emit light with wavelength tuned in a range including from infrared wavelength to ultraviolet wavelength. The invention from a sixth aspect provides the light-emitting device, characterized in that the semitransparent surface electrode comprises a metal thin film, a carbon thin film, an n-type semiconductor thin film or a p-type semiconductor thin film.

Further, the invention from a seventh aspect provides a multi-color light emitting device or an information display device which is formed by finely arraying above-mentioned light-emitting device whose luminescence wavelength bands are different or are controlled.

In the present invention, the electrons accelerated ballistically are injected into the luminous layer with high efficiency, so that an electron-hole pair is generated with high density, thereby improving the luminous efficiency. Further, injection of holes from the holes supply layer is utilized so that the luminous efficiency is further increased. Since selectivity of the luminous layer is widened, tuning of the luminescence wavelength in a range including from infrared wavelength to ultraviolet wavelength is facilitated. Further, the light-emitting device is fabricated by a monolithic process, thereby enabling high integration.

### Brief Description of Drawings

Fig. 1 is a pattern diagram illustrating a device structure according to Example 1.
Fig. 2 is a diagram illustrating a voltage-current characteristic with respect to presence/non-presence of an electron drift layer.
Fig. 3 is a diagram illustrating a voltage-luminescence intensity characteristic with respect to the presence/non-presence of the electron drift layer.
Fig. 4 is a diagram illustrating a current-luminescence intensity characteristic with respect to the presence/non-presence of the electron drift layer.
Fig. 5 is a diagram illustrating a voltage-current characteristic with respect to presence/non-presence of a holes supply layer.
Fig. 6 is a diagram illustrating a voltage-luminescence intensity characteristic with respect to the presence/non-presence of the holes supply layer.
Fig. 7 is a diagram illustrating a current-luminescence intensity characteristic with respect to the presence/non-presence of the holes supply layer.
Fig. 8 is a diagram illustrating an energy distribution of emitted electrons from a diode without the luminous layer.
Fig. 9 is a diagram illustrating a photoconductive signal in the electron drift layer observed by a picoseconds time-of-flight method.
Fig. 10 is a diagram illustrating comparison of an electron drift velocity, nc-PS designates nanocrystalline porous silicon, and c-Si designates silicon.
Fig. 11 is a pattern diagram illustrating the device structure corresponding to Example 2.
Fig. 12 is a diagram illustrating a voltage-current characteristics with respect to presence/non-presence of the electron drift layer and the holes supply layer, and illustrating a characteristic of a device in which nanocrystalline silicon is used for the luminous layer.
Fig. 13 is a diagram illustrating a voltage-luminescence intensity characteristic with respect to the presence/non-presence of the electron drift layer and the holes supply layer, and illustrating luminescence intensity of a device in which nanocrystalline silicon is used for the luminous layer.
Fig. 14 is a diagram illustrating a control characteristic of a luminescence wavelength band with provision of the electron drift layer.
Figs. 15 is a diagram illustrating monolithic integration of the light-emitting device.

### Best Mode for Carrying Out the Invention

The present invention has the above characteristics, and embodiments are explained below.

In the above-mentioned structure of the device, an electron drift layer which is important in the invention is a layer that accelerates electrons with low scattering loss before injection into a luminous layer. This layer can have various forms, and examples of them include a layer obtained in a manner that a semi-insulating film, a semiconductor film having a nanocrystalline structure such as nanocrystalline silicon, a semiconductor film or a polycrystalline semiconductor film such as silicon is subject to nanocrystallizing treatment. In these layers, the nanocrystalline silicon layer which produces a quantum effect can be used preferably. In this layer, some of electrons sequentially tunnel through barriers between nanocrystals by the effect of high electric field, generated in a nanocrystalline interface, and travel ballistically without scattering and energy loss. As a result; electrons acquire kinetic energy just like electrons accelerated in vacuum. This electron drift layer can be formed by using, for example, a self-organizing process of anodization.

High-energy electrons generated in the electron drift layer are injected into the luminous layer so that an electron-hole pairs with a high density is generated, and this enables efficient light emission in a range from infrared ray to ultraviolet ray. Further, the introduced holes supply layer enhances radiative recombination.

Nanocrystalline silicon whose size is controlled or nanocrystalline silicon with which a rare-earth element such as erbium is doped is used as the luminous layer. As a result, a silicon-based light-emitting device, which has arbitrary luminescence wavelength in a range from infrared ray to ultraviolet ray, is realized, thereby enabling highly monolithic optical integration.

Then, by showing the examples hereafter, the present invention will be explained in further details. Of course, the present invention is not limited by the following examples shown below.

### Examples

### <Example 1>

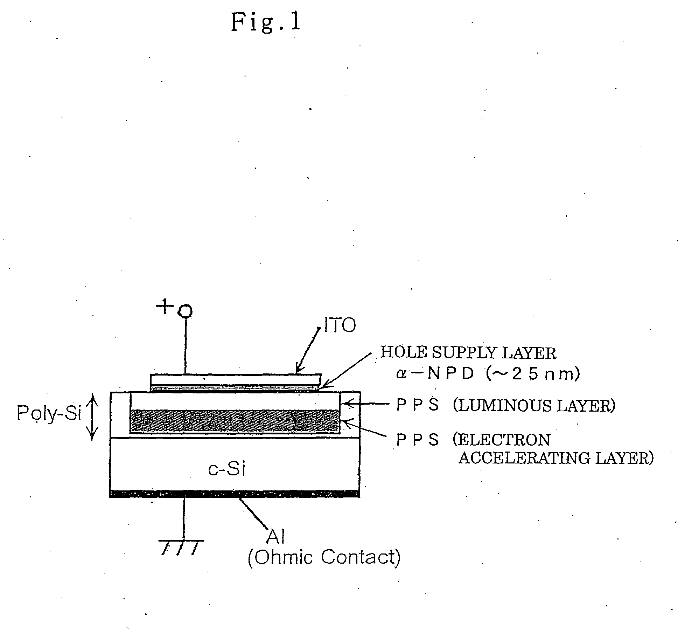

Fig. 1 is a schematic structural diagram illustrating a surface light-emitting device as one example of the invention. In this example, a polysilicon layer with a thickness of 1.6 µm is deposited on a crystalline n-type silicon substrate (up to 0.01 Ωcm) by the LPCVD method. After donor impurity Phosphor is injected into the surface of the polysilicon layer by the ion implantation method at an accelerating voltage of 150 KeV and dose of 4.5 × 10¹⁵ cm⁻², the substrate is annealed at 1000°C for 10 minutes. In this case, the dose amount is appropriately changed so that an arbitrary luminescence wavelength can be obtained.

A two-layer structure including the luminescent layer and the electron drift layer is formed in the polysilicon layer by anodizing method. In order to obtain the two-layer structure, the luminescent layer and the electron drift layer are gradually anodized in this order while the condition is being changed. The anodizing is carried out in a mixed solvent of HF and C₂H₅OH for 30 seconds at a current density of 50 mA/cm² under illumination by white light of 1W/cm² is being emitted, so that the luminous layer is formed up to a depth of 700 nm from the surface. The anodizing is, then, carried out for 25 seconds at a current density of 65 mA/cm² under illumination by white light of 1W/cm² so that the electron drift layer is formed into a depth of 700 nm to 1.4 µm.

In this example, the n-type silicon substrate is used as the substrate, but when an electrode is deposited on an insulating substrate such as a glass substrate or a plastic sheet and a polysilicon layer is deposited thereon, the similar device can be fabricated, thereby facilitating enlargement of an area.

After the anodization, electrochemical oxidizing treatment is processed in H₂SO₄ of 1M at a current density of 3 mA/cm² until electrochemical EL luminescence intensity during the treatment becomes a maximum. As a matter of course, instead of the electrochemical oxidizing treatment, means such as oxygen plasma treatment or rapid thermal oxidizing treatment can be used.

α-NPD is evaporated on an upper surface of the luminous layer so that the holes supply layer is formed. α-NPD is generally known as an organic holes supply layer, and has resistance to heat.

Except for the holes supply layer using α-NPD, the following method can be used. After acceptor impurity Boron ion is implanted into an outermost surface of the polysilicon layer at acceleration voltage 30 keV with a dose of 1×10¹⁵ cm⁻² so that a P-type layer is formed, the P-type layer is annealed at 1000°C for ten minutes, and a three-layer structure including the holes supply layer, the luminous layer and the electron drift layer is formed in the polysilicon layer by using the anodizing method. The introduction of the holes supply layer can enhance the luminous efficiency, but the holes supply layer is not formed but a surface electrode is formed directly on the luminous layer, so that sufficient luminescence intensity can be obtained.

Finally; a semitransparent surface electrode is formed on the luminous layer. An ITO film used in the example of Fig. 1 can be not only the semitransparent surface electrode but also the holes supply layer.

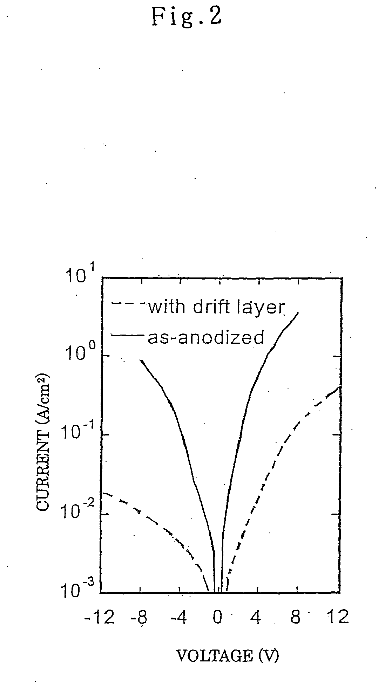

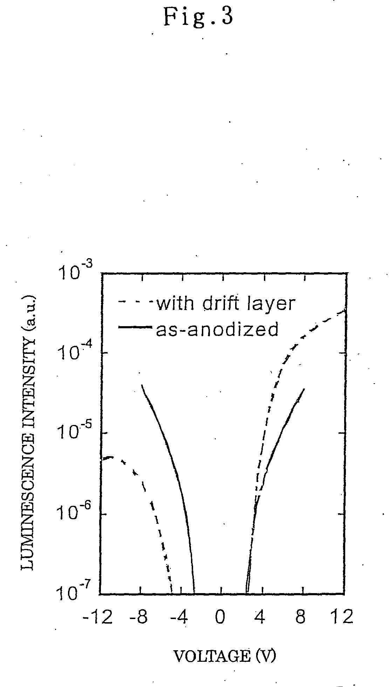

The characteristics of the obtained device are explained below. A typical current-voltage characteristic and a change in the corresponding luminescence intensity are shown in Figs. 2 and 3. In the figures, "drift layer" represents the electron drift layer. "As-anodized" represents a characteristic of the device without the electron drift layer. When a voltage higher than a positive bias of 3V with respect to the bottom electrode is applied to the semitransparent electrode which is the surface electrode, the uniform light emission in the electrode plane can be observed in the device. The light emission is not generated with negative bias. The luminescence intensity increases abruptly according to an increase in the bias voltage, and the light emission can be clearly observed under day light with a voltage of about 5 V.

This light-emitting mechanism is clearly different from conventional LED. In the conventional LED, it is necessary to simultaneously inject electrons and holes into the luminous layer in order to obtain light emission. On the contrary, in the device of the present invention, a cathode luminescence mechanism in a solid and improvement of the light-emitting recombination due to the holes injection are simultaneously induced. It is considered that the synergy between them brings the high-efficient light emission.

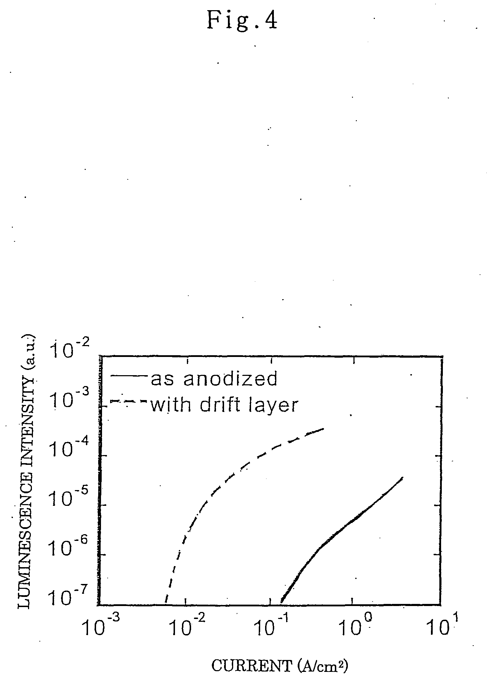

Fig. 4 illustrates comparison of a diode current-luminescence intensity characteristic of the device including the ITO surface electrode, the luminous layer, the electron drift layer, the conductive substrate, and a bottom electrode with the diode current-luminescence intensity characteristic of the device including the ITO surface electrode, the luminous layer, the conductive substrate and the bottom electrode in order to verify the effect of the electron drift layer. It is found that the insertion of the electron drift layer significantly improves the luminescence intensity in comparison to the case of the conventional device. This means that electron-hole pairs are generated with a high density in the luminous layer because a ballistic component and a quasi-ballistic component generated in the electron drift layer contribute to impact excitation.

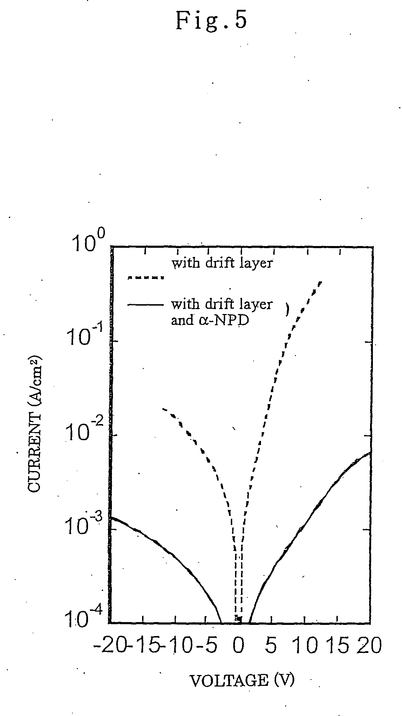

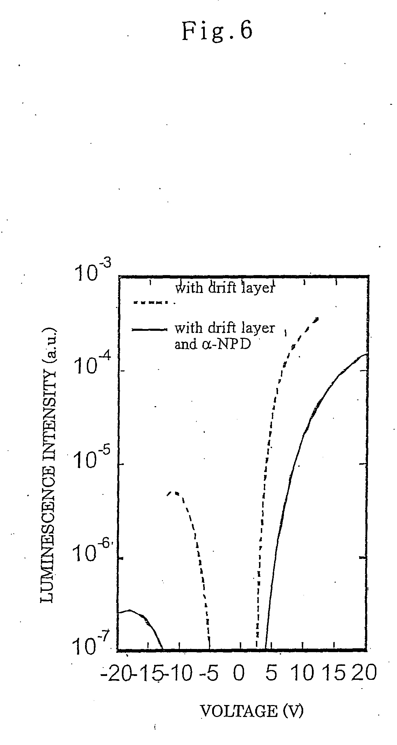

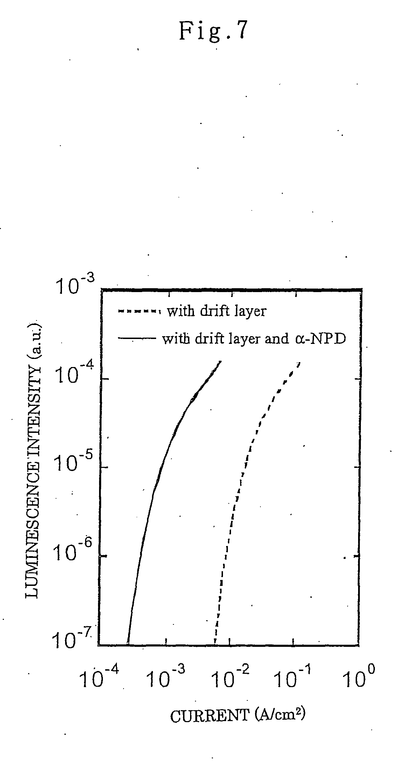

Figs. 5 and 6 illustrate the current-voltage characteristic of the device including the ITO surface electrode, the holes supply layer consisted of α-NPD, the luminous layer, the electron drift layer, the conductive substrate and the bottom electrode, and a change in the corresponding luminescence intensity. Fig. 7 illustrates characteristic of diode current-luminescence intensity. From these results, it is found that the provision of the holes supply layer significantly improves the luminescence efficiency.

An electron energy distribution and an electron drift velocity are explained below as items that support above mentioned cathode luminescence mechanism in the solid by the ballistic electron scheme. In order to verify the ballistic electron generating mechanism in the electron drift layer, the energy distribution of the electrons emitted from the device without the luminous layer and a carrier transport process are measured.

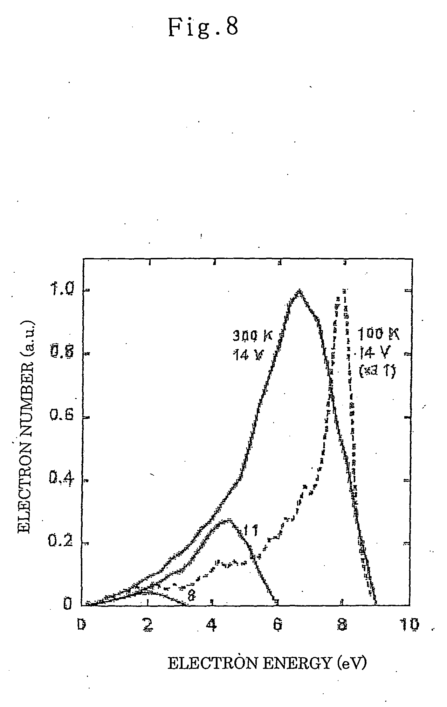

When a positive bias with respect to the surface electrode is applied to this device in vacuum, the electrons are uniformly emitted through the surface electrode. In Fig. 8, kinetic energy of the emitted electrons according to some bias voltages is measured by using an AC retarding field method. The energy is measured with respect to the vacuum level. Every peak of every distribution is on a high-energy side, and the peak shifts to the higher energy side with increasing the bias voltage. This means that the emitted electrons are totally different from thermalized electrons. The energy distribution is narrowed particularly at temperature below 150 K where the electrons are not influenced by thermal excitation, and when the work function of the semitransparent electrode is taken into consideration, the peak reaches 90% or more of the energy expected from the ballistic transport.

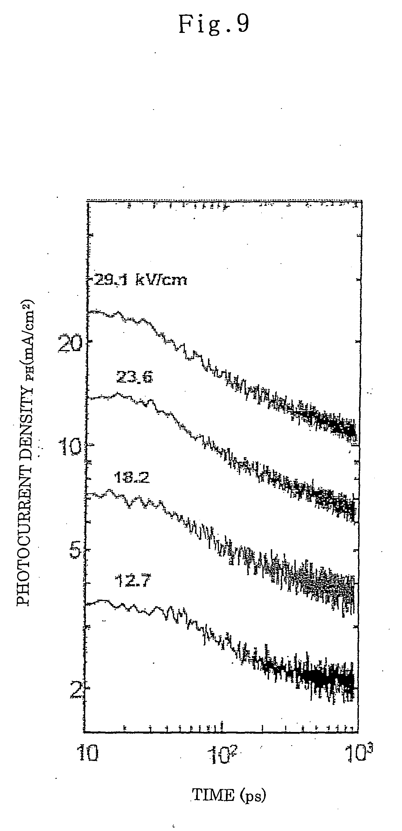

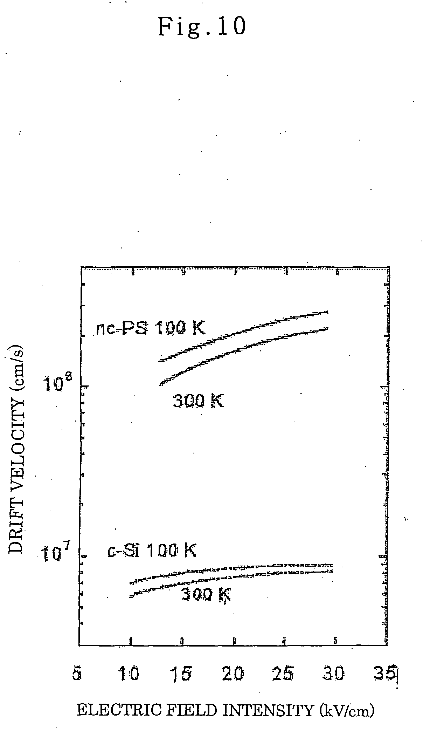

In order to clarify the electron transport process in the electron drift layer, the drift velocity of the electrons is analized by using the time-of-flight method. After the nanocrystalline layer is formed by the anodization similarly, a self-supporting layer consisted of the nanocrystalline silicon is obtained by the electrochemical peeling method. Thin film electrodes are evaporated on both surfaces of the sample layer. The short-width laser pulse is used as excitation through semitransparent electrode. Fig. 9 illustrates a characteristic of a photocurrent transient response after a picoseconds ultraviolet laser pulse incidence at different applied electric field. The figure illustrates the transient characteristic at longer time. At the time of measurement, when the electrons photo-generated near the electrode drift towards a counter electrode, they induce a transient current signal. After the electrons reach the counter electrode, the current decreases, and thus the drift velocity of the electrons can be obtained from the time at which the signal current starts to be attenuated. Fig. 10 illustrates a change in the drift velocity as a function of the electric field. For comparison, Fig. 10 illustrates the drift velocity in the case of the silicon where the ballistic transport is not induced. Data about the silicon are from C. Canali, G. Ottaviani and A. Alberigi Quaranta, J. Phys. Chem. Solids: 32,1707 (1971). In the silicon, the drift velocity of the electrons shows a definite saturation at an electric field of 30 kV/cm as a result of frequent electron-phonon scattering. On the contrary, in the nanocrystalline silicon layer, the drift velocity is not saturated even in the high electric field, and energy dispersion is suppressed.

The drift velocity of the electrons at 30 kV/cm is 20 or more times as high as that of the silicon. In order that the drift velocity obtains this value, it is necessary that the electrons have an mean free path corresponding to a distance which is several hundred times as large as a mean size of the nanocrystals, and are accelerated ballistically over 1.6 µm through nanocrystalline silicon dot chains interconnected via thin tunnel oxide barrier. At the same time, when a drift length of the electrons is obtained from the product of mobility-lifetime obtained by the photocurrent transient characteristic, the value is 3.2 µm. This means that the electrons accelerated in the electron drift layer are seldom trapped but are accelerated so as to be injected into the luminous layer with sufficient energy.

The nanocrystalline silicon drift layer is consisted of a lot of nanocrystalline silicon dot chains. When the bias voltage is applied to this layer, a major voltage drop occurs at the interfacial oxides bewteen nanocrystalline silicon. Since the electric field generated at the nanocrystalline interface has a spike-like profile, the electrons can obtain the high kinetic energy as a result of multiple-tunneling transport. As far as the trap density is fully suppressed in the electron drift layer, the non-thermalized ballistic electrons or the quasi-ballistic hot electrons are efficiently generated. Since the electron energy near the outer surface reaches 10 eV as shown in Fig. 8, the electron-hole pairs with high density can be generated in the luminous layer.

### <Example 2>

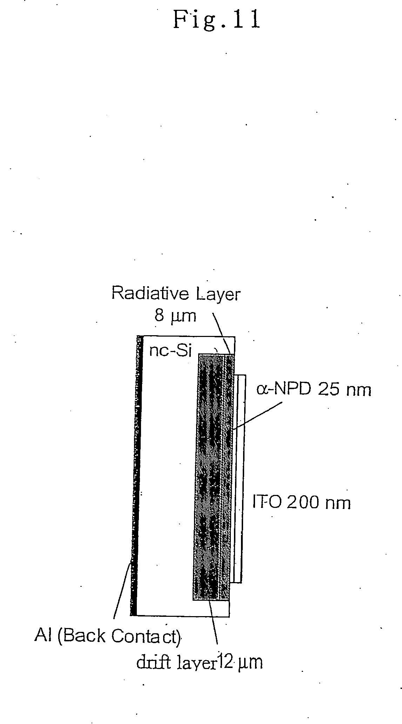

An n-type Si substrate of 0.02 to 0.07 Ωcm is anodized at an anodization current density of 100 mA/cm² in a mixed solvent of HF and C₂H₅OH for 150 seconds under illumination by a white light of 1 W/cm² so that the luminous layer is formed. The current density is raised from 100 mA/cm² to 200 mA/cm² in the solvent by current modulation anodization so that the electron drift layer is formed underneath the luminous layer. Thereafter, the substrate is subject to surface termination treatment in an atmosphere of hydrogen for 12 hours in order to stabilize the device. α-NPD is evaporated on the upper surface of the luminous layer so that the holes supply layer is formed. In this example; α-NPD is used as the holes supply layer, but the following method can be used. Acceptor impurity Boron is implanted into the outermost surface of the polysilicon layer at acceleration voltage of 30 keV with a dose of 1×10¹⁵ cm⁻² so that a P-type layer is formed. Thereafter, the polysilicon layer is annealed at 1000°C for 10 minutes, and a three-layer structure including the holes supply layer, the luminous layer and the electron drift layer can be formed by using the anodizing method. Finally, the ITO thin film is deposited thereon by the sputtering method so as to be a surface electrode. The structure of the fabricated device is shown in Fig. 11.

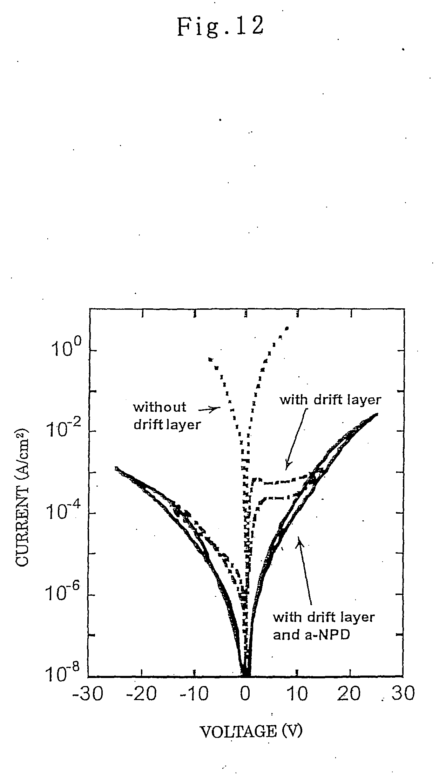

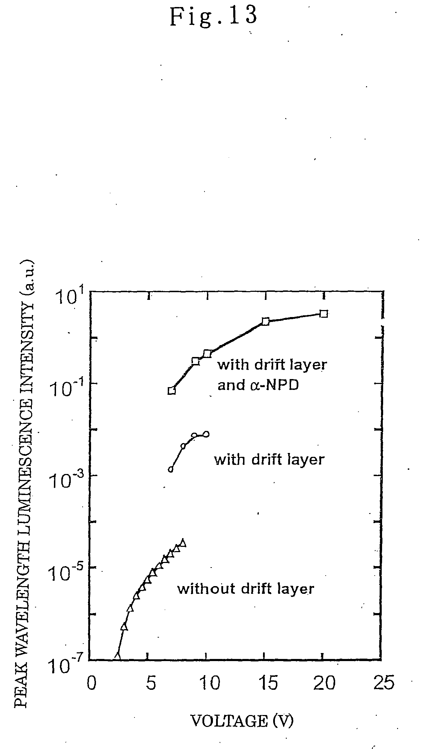

The characteristics of this device are explained below. Figs. 12 and 13 illustrate the typical current-voltage characteristic and a change in the corresponding luminescence intensity. In the figures, "drift layer" designates the electron drift layer. The uniform light emission can be observed in the electrode part of the device, and the light emission is not generated with a negative bias. The device with the electron drift layer, the light emission can be clearly observed at a voltage of about 5V under day light. As explained in Example 1, in the device of the present invention, since the ballistic component and the quasi-ballistic component which are generated in the electron drift layer abruptly increase with increasing the applied voltage, the luminescence is further enhanced by the employing the holes supply layer. Actually one can see that the provision of the holes supply layer significantly improves the luminescence efficiency.

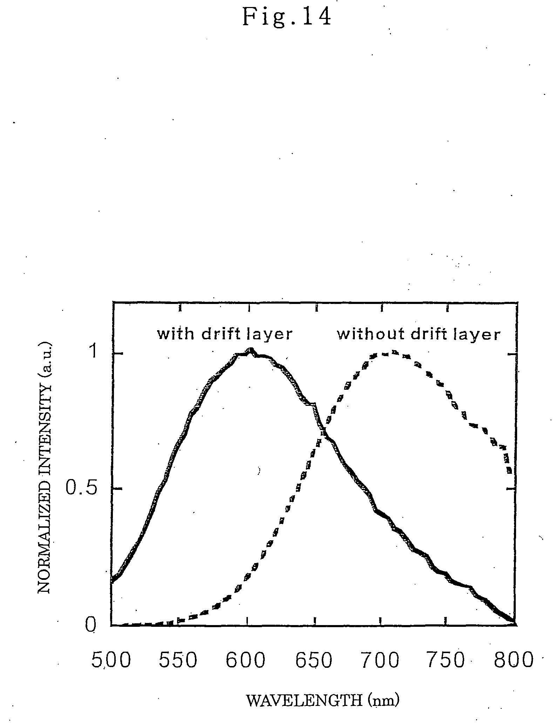

Fig. 14 illustrates an emission spectrum measured simultaneously. In the device with the electron drift layer, the spectrum shows the yellow light emission whose peak wavelength is about 590 nm. In this device, the wavelength is 100 nm higher and the energy is 0.3 eV higher than those of the device without the electron drift layer. In the device without the electron drift layer, since the electrons to be injected into the luminous layer are thermalized ones, the luminous layer, in which the size of the nanocrystal is small and a band gap is large (namely, high excitation energy is required), cannot be excited. On the other hand, in the device with the electron drift layer, since the electrons to be injected into the luminous layer are ballistic, an original energy gap of the luminous layer determined by the size of the nanocrystal can be excited, and thus the light emission energy becomes high. This experimental result suggests that the electron drift layer enables a multi-color EL with high efficiency.

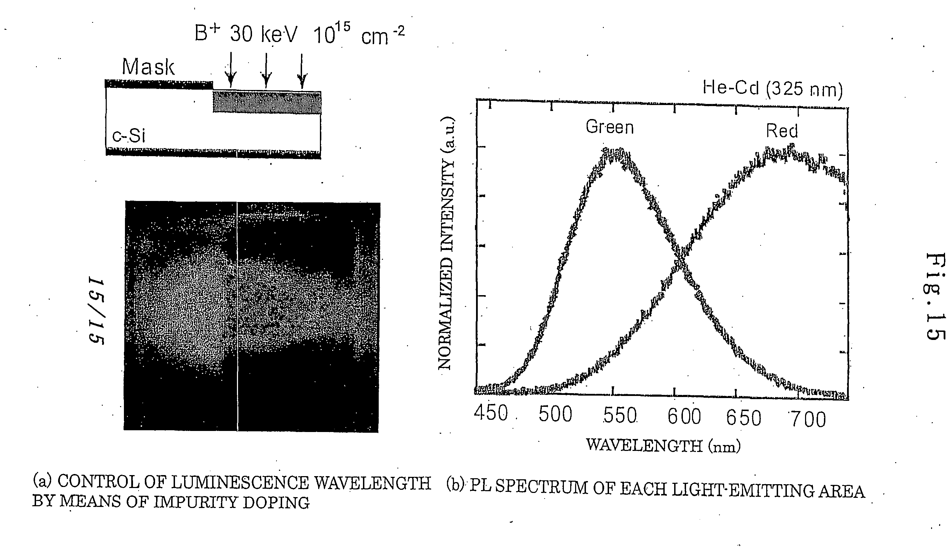

Further, arbitrary luminescence wavelength can be obtained in a predetermined place in the plane of the luminous layer by increasing/decreasing an impurity dope amount and creating the device according to the anodizing method. This example is shown in Figs. 15(a) and 15(b). Since the size of the nanocrystal in the plane of the luminous layer can be controlled arbitrarily according to the doping level, the luminescence wavelength can be tuned arbitrarily, and the multi-color EL devices can be integrated in a monolithic manner.

### Industrial Applicability

As detailed above, according to the present invention, the new light-emitting device can improve the important aspects in this field: the luminous efficiency, tuning of the luminescence wavelength, power consumption, a response speed, compatibility with enlargement of an active area, environmental compatibility, reliability, low-cost production, thinning, and integration capability. This brings a great industry effect to not only the development of the light-emitting device but also the general information terminal technology.

## Claims

1. A light-emitting device comprising a semiconductor or a conductive substrate having a bottom electrode, an electron drift layer for generating hot electrons, quasi-ballistic electrons or ballistic electrons, a luminous layer, and a semitransparent surface electrode.

2. The light-emitting device according to claim 1, wherein a holes supply layer is deposited between the luminous layer and the semitransparent surface electrode, and a holes are is injected into the luminous layer under operation.

3. The light-emitting device according to claim 1 or 2, wherein the substrate comprises a glass plate or a plastic sheet coated with an electrode.

4. The light-emitting device according to any one of claims 1 to 3, wherein the electron drift layer comprises a layer which is obtained in a manner that a semi-insulating film, a semiconductor film having a nanocrystalline structure, a semiconductor film or a polycrystalline semiconductor film is subject to nanocrystallization treatment.

5. The light-emitting device according to any one of claims 1 to 3, wherein the luminous layer comprises a luminescent semiconductor, a luminescent semiconductor nanostructure, an inorganic fluorescent material or an organic fluorescent material, and can emit light with arbitrary wavelength in a range including from infrared wavelength to ultraviolet wavelength.

6. The light-emitting device according to any one of claims 1 to 3, wherein the semitransparent surface electrode comprises a metal thin film, a carbon thin film, an n-type conductive thin film or a p-type conductive thin film.

7. A multi-color light emitting device or an information display device which is composed of finely arrayed light-emitting devices according to any one of claims 1 to 6 whose luminescence wavelength bands are different or are tuned.
